(19) Europäisches Patentamt
European Patent Office
Office européen des brevets

(11) **EP 3 643 809 A1**

(12) **EUROPÄISCHE PATENTANMELDUNG**

(43) Veröffentlichungstag:
**29.04.2020 Patentblatt 2020/18**

(51) Int Cl.:
*C23C 16/54* (2006.01)  *C23C 16/455* (2006.01)
*C23C 16/04* (2006.01)  *B01D 67/00* (2006.01)
*C23C 16/44* (2006.01)

(21) Anmeldenummer: **19204513.6**

(22) Anmeldetag: **22.10.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **22.10.2018 DE 102018218008**

(71) Anmelder: **Fraunhofer-Gesellschaft zur Förderung der angewandten Forschung e.V. 80686 München (DE)**

(72) Erfinder:
• **Bauer, Klaus Dieter**
  **85354 Freising (DE)**
• **Busch, Wolfgang**
  **85354 Freising (DE)**
• **Reinelt, Matthias**
  **85354 Freising (DE)**

(74) Vertreter: **Gagel, Roland Patentanwaltskanzlei Dr. Roland Gagel Landsberger Strasse 480 a D-81241 München (DE)**

(54) **VERFAHREN ZUR BILDUNG EINER SCHICHT ODER EINZELNER CLUSTER EINES MATERIALS IN UND/ODER AUF EINEM SUBSTRAT**

(57)   Bei einem Verfahren zur Bildung einer Schicht (4) oder einzelner Cluster (3) eines Materials durch chemische Reaktion von wenigstens zwei Reaktanten an und/oder unter einer Oberfläche eines Substrats (1), das für einen der Reaktanten permeabel ist, werden die wenigstens zwei Reaktanten von gegenüberliegenden Seiten der Substratoberfläche zugeführt. Dies ermöglicht die Beschichtung von permeablen Materialien wie z.B. Polymerfolien, in besonders einfacher Weise und mit minimalem Einsatz von Energie, insbesondere zur Erzeugung von Barrierebeschichtungen, in industriellem Maßstab.

Fig. 1

EP 3 643 809 A1

**Beschreibung**

**Technisches Anwendungsgebiet**

Die vorliegende Erfindung betrifft ein Verfahren zur Bildung einer Schicht oder einzelner Cluster eines Materials durch chemische Reaktion von wenigstens zwei Reaktanten an und/oder unter einer Oberfläche eines Substrats, das für einen der Reaktanten permeabel ist, insbesondere zur Erzeugung einer Permeationsbarriere.

Schichten auf oder innerhalb von Substraten werden für zahlreiche Anwendungen benötigt, um beispielsweise Barriere- oder Schutzfunktionen zu erzielen. So weisen insbesondere Polymerfolien eine mehr oder weniger große Permeabilität für gasförmige Substanzen wie z.B. Wasserdampf, Sauerstoff und Kohlendioxid auf, die für viele Anwendungen in der Verpackungstechnik nachteilig ist. Zur Erzielung ausreichender Barriere-Eigenschaften werden diese Folien daher mit verschiedensten Methoden mit dünnen, undurchlässigeren Beschichtungen versehen und zum Teil zusätzlich zu Mehrschichtverbunden laminiert. Besonders die zur Erzeugung von sog. Ultrabarrieren angewandten Beschichtungsprozesse sind jedoch aufwändig und relativ langsam und daher für die Massenproduktion weniger geeignet.

**Stand der Technik**

Das Problem der unzureichenden Barrierefunktion von Polymeren wird in der Regel durch Beschichtung mit anorganischen Materialien, wie z.B. Al, $Al_2O_3$ oder $SiO_2$, gelöst. Dabei kommen meist PVD- und CVD-Verfahren zum Einsatz. Zur Erzeugung von Ultrabarrieren wird gegenwärtig die Atomlagenabscheidung (ALD) vom Pilotmaßstab in industrietaugliche Herstellungsanlagen überführt. Ultrabarrieren werden vor allem für Produkte der organischen Elektronik wie beispielsweise flexible OLED oder OPV benötigt, bei denen die Anforderungen bezüglich der Wasserdampf- und Sauerstoff-Barriere besonders hoch sind. Für diese Anwendungen werden Wasserdampf-Transmissionsraten (WV-TR) < $10^{-5}$ $g/m^2/d$ und Sauerstoff-Transmissionsraten (OTR) < $10^{-5}$ $cm^3(STP)/m^2/d/bar$ gefordert.

Bei der Atomlagenabscheidung wird eine chemische Reaktion zwischen zwei Reaktanten ausgenutzt, die zu der Schicht aus dem gewünschten Material führt. Einer oder beide Reaktanten stellen dabei in der Regel eine Vorläufersubstanz für das Material, auch als Precursor bezeichnet, dar. Hierbei ist es notwendig, dass die Reaktionen zwischen den Reaktanten nur auf der zu beschichtenden Oberfläche, nicht aber in der Gasphase ablaufen. Hierzu sind zwei prinzipielle Varianten dieser Atomlagenabscheidung bekannt.

Bei der ersten Variante wird das zu beschichtende Substrat in einen geschlossenen Reaktionsraum eingebracht, der evakuiert und/oder mit Inertgas gespült wird, um jegliche gasförmigen Verunreinigungen wie z.B. Wasser und Sauerstoff möglichst vollständig zu entfernen. Die Schichtabscheidung findet dann in sich wiederholenden Schritten statt, die im Folgenden kurz beschrieben werden. Zunächst wird der Reaktionsraum mit einem inerten Trägergas befüllt, welches eine dampfförmige reaktive Substanz als Precursor, z.B. Trimethylaluminium (TMA), mit sich führt. Die Oberfläche des zu beschichtenden Substrats wird dabei mit einer Monolage der ersten Precursor-Moleküle bedeckt. Anschließend wird der Reaktionsraum wieder evakuiert und/oder gespült, bis das Volumen bis auf die Substratoberfläche möglichst frei von Molekülen des ersten Precursors ist. Analog zum ersten Schritt wird dann der Reaktionsraum wieder mit einem Trägergas befüllt, welches nun einen zweiten Precursor (z.B. Wasserdampf) enthält. Der zweite Precursor reagiert mit den auf der Substratoberfläche angelagerten Molekülen des ersten Precursors. Es bildet sich das gewünschte Reaktionsprodukt. Im Falle von TMA und Wasser als erster und zweiter Precursor ist dies Aluminiumoxid, wobei als Nebenprodukt in diesem Fall gasförmiges Methan anfällt. Im Idealfall bildet sich auf diese Weise eine Atomlage Aluminiumoxid. Der Reaktionsraum wird anschließend wieder evakuiert und/oder sauber gespült. Diese Abfolge wird so lange wiederholt, bis die gewünschte Schichtdicke erreicht ist.

Bei der zweiten Variante, der so genannten "Spatial ALD" werden räumlich getrennte Precursorzonen in unmittelbarer Nachbarschaft der zu beschichtenden Oberfläche genutzt. Diese getrennten Zonen werden z.B. durch spezielle Beschichtungsköpfe erzeugt, wie dies bspw. in P. Poodt et al., "High-Speed Spatial Atomic-Layer Deposition of Aluminum Oxide Layers for Solar Cell Passivation", Adv. Mater. 22, 2010, Seiten 3564 bis 3567 beschrieben ist. Durch eine relative Bewegung zwischen Beschichtungskopf und zu beschichtender Oberfläche wird die Schicht analog zur ersten Variante Atomlage für Atomlage aufgebaut. Ein Vorteil dieser zweiten Variante besteht darin, dass sie unter Atmosphärendruck arbeitet und etwa einen Faktor 10 schneller als die erste Variante ist. Auch wenn die Spatial ALD wesentlich schneller als das konventionelle Verfahren der ersten Variante ist, stellt die Hochskalierung in den industriellen Maßstab eine große technische Herausforderung dar, besonders bei Verwendung von breiten und sehr dünnen Folienbahnen.

Weiterhin ist beispielsweise aus C.Z. Leng et al., "Vapor phase infiltration (VPI) for transforming polymers into organic-inorganic hybrid materials: a critical review of current progress and future challenges", Mater. Horiz., 2017, 4, Seiten 747 bis 771, ein gepulstes Infiltrationsverfahren als Abwandlung der ALD bekannt. Die Prozessierung kann hierbei mit den üblichen ALD-Precursoren in allen herkömmlichen ALD-Systemen durchgeführt werden. Der Unterschied zur ALD besteht darin, dass den Precursoren über einen wesentlich längeren Zeitraum erlaubt wird, mit dem Substrat in Wechselwirkung zu treten, z.B. auch tiefer in das Substratmaterial einzuwandern und dort zu reagieren. Meistens werden auch hier Reaktionspaare wie TMA/$H_2O$ verwendet. Es kann jedoch auch mit einem einzigen Precursor ohne zweiten Reaktanten gearbeitet werden. Durch die sequentielle Infiltration von Polymerfolien mit TMA wurden beispielsweise in der WO 2016/012046 A1 gute Sauerstoffbarrieren erzielt. Allerdings sind die Prozesszeiten bei dieser Technik der Infiltration noch länger als bei typischen ALD-Beschichtungen und damit für die Massenproduktion wenig geeignet.

Mittels ALD ist die Herstellung von ultradünnen Beschichtungen mit der bisher besten Barriere-Wirkung erreicht worden. Allerdings sind die bisher eingesetzten Abscheidevarianten entweder für die Massenproduktion noch zu langsam oder besonders bei Verwendung von breiten und sehr dünnen Folienbahnen schwierig umzusetzen.

Die Aufgabe der vorliegenden Erfindung besteht darin, ein Verfahren zur Bildung einer Schicht auf und/oder in einem Substrat anzugeben, das die Erzeugung einer Barrierebeschichtung auf permeablen Folienmaterialien ermöglicht und bei vergleichbarer Schichtqualität wesentlich einfacher und schneller als die ALD durchgeführt werden kann und damit auch für eine kosteneffiziente Massenproduktion geeignet ist.

## Darstellung der Erfindung

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie den Ausführungsbeispielen entnehmen.

Bei dem vorgeschlagenen Verfahren wird oder werden eine Schicht oder einzelne Cluster eines Materials durch chemische Reaktion von wenigstens zwei Reaktanten bzw. Precursoren in und/oder auf einem Substrat gebildet, das für einen der Reaktanten permeabel ist. Die wenigstens zwei Reaktanten werden bei dem vorgeschlagenen Verfahren von gegenüberliegenden Seiten der Oberfläche des Substrats zugeführt.

In einer Verfahrensausgestaltung werden die beiden Reaktanten hierbei durch das Substrat voneinander getrennt von gegenüberliegenden Seiten des Substrats zugeführt, so dass sie erst nach dem Durchdringen des Substrats unter Bildung der Schicht oder einzelnen Cluster miteinander reagieren. Die Zuführung erfolgt dabei also am jeweils gleichen Abschnitt des Substrates zur gleichen Zeit von den gegenüberliegenden Seiten. Ist das Substrat nur für einen der beiden Reaktanten permeabel, so erfolgt die Schichtbildung an einer der Oberflächen des Substrates, nachdem dieser eine Reaktant das Substrat bis zu dieser Oberfläche durchdrungen hat. Weist das Substrat auch für den anderen Reaktanten eine gewisse Permeabilität auf, so erfolgt die Bildung der Schicht oder Cluster wenigstens zum Teil innerhalb des Substrats. Das Substrat muss hierbei für den wenigstens einen Reaktanten so permeabel sein, dass dieser das Substrat vollständig durchdringen kann, um auf die gegenüberliegende Seite des Substrates zu gelangen.

In einer anderen Verfahrensausgestaltung wird einer der zwei Reaktanten vor der Zuführung des anderen Reaktanten in dem Substrat bzw. Substratmaterial gelöst, insbesondere bei einem Polymersubstrat, oder in dem Substrat angereichert, beispielsweise bei einem porösen Substratmaterial. Nach Zuführung des anderen Reaktanten erfolgt dann die Bildung der Schicht oder einzelnen Cluster an der Oberfläche des Substrats. Das Substrat dient hierbei als Reservoir für den einen Reaktanten.

Die beiden Reaktanten werden beim vorgeschlagenen Verfahren vorzugsweise in gas- oder dampfförmigem Zustand, beispielsweise mittels eines geeigneten Trägergases, zugeführt. Als Trägergas kommt z.B. Luft, Sauerstoff, Stickstoff, Kohlendioxid, Kohlenmonoxid, Helium, Neon, Argon, Krypton und Xenon in Frage. Prinzipiell ist jedoch auch eine Zuführung in flüssigem Zustand, auch mittels einer geeigneten Trägerflüssigkeit, möglich. Die chemische Reaktion der mindestens zwei Reaktanten führt zur vorzugsweise irreversiblen Bildung von mindestens einem Feststoff, welcher das vorgesehene Beschichtungsmaterial darstellt. Darüber hinaus können Reaktionsnebenprodukte entstehen, welche in dem vorgeschlagenen Verfahren wieder abgeführt werden.

Das vorgeschlagene Verfahren nutzt die Reaktionen von Precursoren, wie sie auch bei CVD- und ALD-Prozessen Anwendung finden. Die chemischen Reaktionen sind dabei analog wie bei der ALD, allerdings handelt es sich dabei eher um eine Abscheidung von Atom- bzw. Molekül-Clustern als von Atom- bzw. Molekül-Lagen wie bei der ALD. Während bei dem letztgenannten Prozess die Schichtbildung Atom- bzw. Moleküllage für Atom- bzw. Moleküllage gleichmäßig erfolgt, bilden sich bei dem vorgeschlagenen Verfahren vornehmlich einzelne Atom- bzw. Molekülcluster, die im weiteren Verlauf des Verfahrens dann zu einer Schicht zusammenwachsen. Über eine Kontrolle der Dauer der Verfahrensführung lassen sich somit sowohl zusammenhängende Schichten als auch einzelne Cluster auf und/oder in dem Substrat erzeugen.

Ein wesentliches Merkmal des vorgeschlagenen Verfahrens besteht darin, dass alleine das Substrat die Reaktanten bzw. Precursoren räumlich voneinander trennt, allerdings zumindest für einen von ihnen eine ausreichende Permeabilität aufweist, so dass dieser durch das Substrat hindurch zum anderen Reaktanten bzw. Precursor gelangen kann. Je nach Wahl der Reaktanten lässt sich die Schichtbildung dabei auf die Oberfläche beschränken oder auch in das Volumen des Substrats verschieben. In ersterem Fall ist das Substrat für einen der Reaktanten nicht permeabel, in dem anderen Fall weist das Substrat auch eine Permeabilität für den anderen Reaktanten auf. Die Geschwindigkeit der Bildung der Schicht bzw. der einzelnen Cluster kann über die Temperatur des Substrats und über den Partialdruck des Reaktanten gesteuert werden, für den das Substrat permeabel ist. Bei gegebener Substratdicke steigt die Permeationsrate proportional zum Partialdruck und exponentiell mit der Temperatur an. Die Prozesstemperatur ist prinzipiell lediglich durch die Zersetzungstemperatur des Substratmaterials nach oben begrenzt. Typische Prozessparameter sind im Folgenden angeführt:

Temperaturbereiche: 273 - 773 K, bevorzugt 273 - 523 K, besonders bevorzugt 293 - 473 K.
Partialdruckbereiche: 0,00001 - 5 bar, bevorzugt 0,0001 - 2 bar, noch besser 0,001 - 1 bar, besonders bevorzugt 0,01 - 1 bar.
Gesamtdruckbereiche: 0,00001 - 5 bar, bevorzugt 0,0001 - 2 bar, noch besser 0,001 - 2 bar, besonders bevorzugt 0,01 - 1,5 bar.

Die Substratdicken liegen beispielsweise im Bereich 0,2 $\mu$m - 10 mm, bevorzugt 0,5 $\mu$m - 2 mm, noch besser 0,5 $\mu$m - 500 $\mu$m, besonders bevorzugt 0,5 $\mu$m - 200 $\mu$m.

Besonders vorteilhaft eignet sich Wasser bzw. Wasserdampf als einer der Reaktanten, für den viele Substratmaterialien, insbesondere Polymermaterialien, durchlässig sind. Das Verfahren eignet sich besonders zur Verbesserung der Barriere-Eigenschaften von Polymerfolien. Hierzu können z.B. die Reaktionspaare TMA/$H_2O$, Diethylzink(DEZ)/$H_2O$ oder $TiCl_4$/$H_2O$ verwendet werden.

Als Precursoren können insbesondere organische Verbindungen, metallorganische Verbindungen, organometallische Verbindungen, Halogenide, Chalkogenide oder Silane eingesetzt werden. Besonders geeignet sind Verbindungen der Formel $MR_n$ oder $M_2R_{2n}$, wobei M für ein Metall steht und n = 2, 3 oder 4. M steht z.B. für Al, Ti, Zn, Hf, Zr, W, Mo. R stellt einen organischen Teil wie z.B. eine Alkylgruppe, eine Alkoholgruppe oder eine Arylgruppe dar, oder auch ein Halogen, wie z.B. Cl.

In Abhängigkeit von der zu bildenden Schicht und den zur Schichtbildung eingesetzten Reaktanten bzw. Precursoren und Verfahrensparametern wird das Schichtwachstum entweder automatisch beendet oder dauert innerhalb gewisser Grenzen so lange an, wie die Reaktanten zugeführt werden. Der erste Fall betrifft die Bildung von Barriereschichten, die beispielsweise eine Barriere für Wasserdampf als einen der beiden Reaktanten bilden. Durch Bildung der Schicht nimmt dabei die Geschwindigkeit des Schichtwachstums immer weiter ab, da durch die erzeugte Schicht selbst weniger Wassermoleküle die Oberfläche und damit den zweiten Reaktanten erreichen können. Bei Bildung von Schichten, die für den entsprechenden Reaktanten weiterhin durchlässig sind, können auch größere Schichtdicken erzeugt werden, da das Schichtwachstum so lange andauert wie die beiden Reaktanten auf beiden Seiten des Substrates zugeführt werden.

Mit dem vorgeschlagenen Verfahren lassen sich auch die Permeationseigenschaften von Membranen ändern, indem die Innenwandungen der Permeationskanäle der Membran lokal beschichtet werden und damit den Kanalquerschnitt verengen. Weiterhin lassen sich mit dem Verfahren auch Nanopartikel oder Quantenpunkte in oder auf dem Substrat erzeugen, indem die Zuführung der Reaktanten noch vor einem Zusammenwachsen der Cluster abgebrochen wird. Auch eine Verbesserung der Barriere-Eigenschaften von bereits auf dem Substrat aufgebrachten Barriereschichten ist mit dem Verfahren möglich, indem die noch verbleibende Durchlässigkeit dieser Schichten durch die weitere Schicht- oder Clusterbildung reduziert wird.

Besonders vorteilhaft lässt sich das Verfahren für die Beschichtung von Folien mit einer Barrierebeschichtung einsetzen. Hierzu können unterschiedliche Aufbauten zum Einsatz kommen, wie sie in den Ausführungsbeispielen beispielhaft beschrieben sind. Besonders einfach lassen sich Hohlkörper oder Schläuche bzw. Schlauchfolien beschichten, da in diesem Fall einer der Reaktanten nur in das Innere des Hohlkörpers bzw. des Schlauches eingebracht werden muss, während sich der Hohlkörper oder entsprechende Schlauchabschnitt in einem mit dem anderen Reaktanten gefüllten Reaktionsraum befindet. Je nachdem für welchen der beiden Reaktanten der Hohlkörper oder Schlauch permeabel ist, bildet sich dabei entweder an der Innen- oder an der Außenwandung des Hohlkörpers oder Schlauchs die entsprechende Schicht.

Das Verfahren eignet sich auch für die Beschichtung der Oberfläche eines für beide Reaktanten permeablen Substrats, beispielsweise zur Beschichtung von Textilien oder von Papier. Hierbei wird zunächst eine nur für einen der beiden Reaktanten permeable Folie auf das Substrat aufgebracht und anschließend werden wiederum die Reaktanten von beiden Seiten zugeführt. Die Folie wird nach Bildung der Schicht einfach wieder entfernt.

Als Reaktant, für den das Substrat permeabel ist, wird vorzugsweise Wasser ($H_2O$) eingesetzt. Weitere Beispiele für derartige Reaktanten sind $H_2S$, $H_2O_2$, $H_2$, $O_2$, $O_3$, $CO_2$, CO, NO, $NO_2$, $HNO_3$, $N_2H_4$ oder $NH_3$. Es können auch organische Verbindungen mit molaren Massen kleiner 500 g/mol, insbesondere kleiner 200 g/mol verwendet werden. Zusätzlich kann die Erzeugung von Plasmen sowohl auf einer als auch auf beiden Seiten des Substrates für die Aktivierung der gewünschten Reaktion notwendig sein oder unterstützend wirken. Auch der Energieeintrag über elektromagnetische Strahlung wie z.B. UV oder IR kann die Schichtbildung begünstigen.

Das Verfahren lässt sich zur Bildung von Schichten für die unterschiedlichsten Anwendungen einsetzen. Diese Anwendungen sind nicht auf die Bildung von Barriereschichten beschränkt. Es können auch permeable Schichten oder Schichten lokal selektiv, z.B. zwischen metallischen Leiterbahnen, abgeschieden werden. Außerdem ist auch eine Einbettung von vorher auf das Substrat aufgebrachten Partikeln, z.B. von Kohlenstoff-Nanoröhrchen (CNT), Graphen oder Quantenpunkten (quantum dots), möglich. Bei der Bildung von Schichten, die für den einen Reaktanten, z.B. Wasserdampf, permeabel sind, können relativ große Schichtdicken oder auch Schichtsysteme aus mehreren Schichten unterschiedlicher Materialien erzeugt werden.

Das vorgeschlagene Verfahren erlaubt die Beschichtung bzw. Modifikation von permeablen Substraten wie beispielsweise Polymerfolien in besonders einfacher Weise und mit minimalem Einsatz von Reagenzien und Energie. Die Reaktionspartner können kontinuierlich zugeführt werden, so dass weder eine zeitaufwändige Abfolge von Prozessschritten wie bei der konventionellen ALD noch bewegte Beschichtungsköpfe wie bei der Spatial ALD erforderlich sind. Aufgrund der räumlichen Trennung der Reaktanten durch das Substrat selbst wird auch die Partikelbildung durch Reaktionen in der Gasphase, die bei ALD-Prozessen durch unvollkommene Spülzyklen in geringem Maße praktisch immer auftreten, sehr einfach und effektiv vermieden. Die Komplexität eines kontinuierlichen Produktionsprozesses reduziert sich dadurch erheblich. Es können auch sehr breite, dünne und leicht dehnbare Substrate verarbeitet werden, welche bei den bekannten Rolle-zu-Rolle-ALD-Systemen große Schwierigkeiten bereiten. Dadurch ist das Potential eines für industrielle Produktion notwendigen hohen Durchsatzes gegeben. Des Weiteren ist bei der Bildung von Barriereschichten aufgrund des selektiven - besonders stark auf Bereichen hoher Permeabilität - und selbstbegrenzenden Wachstums eine gebildete Barriereschicht im Mittel dünner als eine mittels ALD aufgebrachte Schicht, welche die gesamte Oberfläche gleichmäßig abdeckt und eine vergleichbare Barrierewirkung besitzt. Es ist bekannt, dass Rissbildung in anorganischen Beschichtungen auf Polymersubstraten mit zunehmender Dicke vermehrt auftritt. Die mit dem vorgeschlagenen Verfahren hergestellte Barriere ist unter diesem Aspekt weniger empfindlich gegenüber mechanischem Stress durch Verformung und Dehnung des Substrates.

Abgesehen von den für Barriereanwendungen geschlossenen Schichten können bei entsprechender Prozessführung auch Nanopartikel oder Quantenpunkte direkt auf oder im Substratmaterial erzeugt werden. Dies gelingt, indem der Prozess beendet wird, sobald eine gewünschte mittlere Größe der gebildeten Cluster erreicht ist. Das ist bedeutend einfacher als die Herstellung und Abscheidung von Quantenpunkten mit den gebräuchlichen Plasma- und Hochtemperaturverfahren, die zudem gar nicht direkt auf temperaturempfindlichen Polymeren anwendbar sind.

Das Verfahren lässt sich insbesondere für Barrierefolien für technische Anwendungen und Pharmazie- und Lebensmittelverpackungen, für Membranen, beispielsweise für die Ultra-/Nano-Filtration, für Batterien oder Brennstoffzellen, zur Funktionalisierung von Textilien, beispielsweise hinsichtlich Benetzung, Schmutzabweisung oder antibakterielle Eigenschaften, und zur Erzeugung von Quantenpunkt-Filmen, beispielsweise für Displays, Beleuchtung, Solarzellen oder Sensoren einsetzen.

**Kurze Beschreibung der Zeichnungen**

Das vorgeschlagene Verfahren wird nachfolgend anhand von Ausführungsbeispielen in Verbindung mit den Zeichnungen nochmals näher erläutert. Hierbei zeigen:

Fig. 1     eine erste beispielhafte Anordnung zur Durchführung des Verfahrens;

Fig. 2     eine schematische Darstellung der zeitlichen Entwicklung bei der Schichtbildung gemäß dem vorgeschlagenen Verfahren;

Fig. 3     eine schematische Darstellung zur Veranschaulichung der Cluster- und Schichtbildung;

Fig. 4     eine Darstellung des schematischen Verlaufs von Schichtwachstum und korrelierter Wasserdampf-Transmissionsrate;

Fig. 5     eine schematische Darstellung der Anwendung des Verfahrens bei einer Membran;

Fig. 6     eine beispielhafte Anordnung für einen kontinuierlichen Produktionsprozess;

Fig. 7     eine Darstellung eines Details der Anordnung der Figur 6;

Fig. 8     ein Beispiel für die Durchführung einer Barrierebeschichtung auf der Innenwandung eines Schlauches;

Fig. 9     eine schematische Darstellung der Beschichtung eines 3D-Objekts mit einer Barriereschicht;

Fig. 10    ein Beispiel für die Beschichtung/ Funktionalisierung von Textilien oder Papier;

Fig. 11    eine schematische Darstellung der Unterstützung des Beschichtungsprozesses durch ein Entladungs-Plasma;

Fig. 12    eine schematische Darstellung der Unterstützung des Beschichtungsprozesses durch Einkopplung von Photonen;

Fig. 13    eine schematische Darstellung einer Anordnung zur gleichzeitigen Beschichtung von zwei Folienbahnen;

Fig. 14    ein Beispiel für die seitliche Abdichtung der Folienbahnen bei der Anordnung der Figur 13;

Fig. 15    ein weiteres Beispiel für die seitliche Abdichtung der Folienbahnen bei der Anordnung der Figur 13;

Fig. 16    ein weiteres Beispiel für die seitliche Abdichtung der Folienbahnen bei der Anordnung der Figur 13;

Fig. 17 ein weiteres Beispiel für die seitliche Abdichtung der Folienbahnen bei der Anordnung der Figur 13;

Fig. 18 ein weiteres Beispiel einer Anordnung zur Behandlung einer Folienbahn;

Fig. 19 eine Detailansicht eines Teils der Anordnung der Figur 18;

Fig. 20 ein Beispiel für eine sequentielle Anordnung mehrerer Beschichtungsmodule;

Fig. 21 ein Beispiel für eine Anordnung zur Beschichtung von Schlauchfolien direkt während der Blasfolienextrusion;

Fig. 22 ein Beispiel für eine Anordnung zur Beschichtung von Kunststoffbehältern;

Fig. 23 eine Darstellung eines Versuchsaufbaus zur Durchführung einer Beschichtung mit unterschiedlichen Beschichtungsparametern;

Fig. 24 eine schematische Darstellung eines mit dem vorgeschlagenen Verfahren hergestellten Mehrschichtsystems aus nanoporösen Schichten;

Fig. 25 ein Beispiel für die Beschichtung der Zwischenräume zwischen nichtpermeablen Strukturen mit dem vorgeschlagenen Verfahren; und

Fig. 26 ein Beispiel für die Einbettung von Partikeln auf einem Substrat mit dem vorgeschlagenen Verfahren.

## Wege zur Ausführung der Erfindung

Im Folgenden werden unterschiedliche Ausgestaltungen und Anordnungen zur Durchführung des vorgeschlagenen Verfahrens beschrieben, bei denen häufig TMA und $H_2O$ als Reaktanten eingesetzt werden. Die dargestellten Beispiele lassen sich natürlich auch mit anderen Reaktionspaaren durchführen.

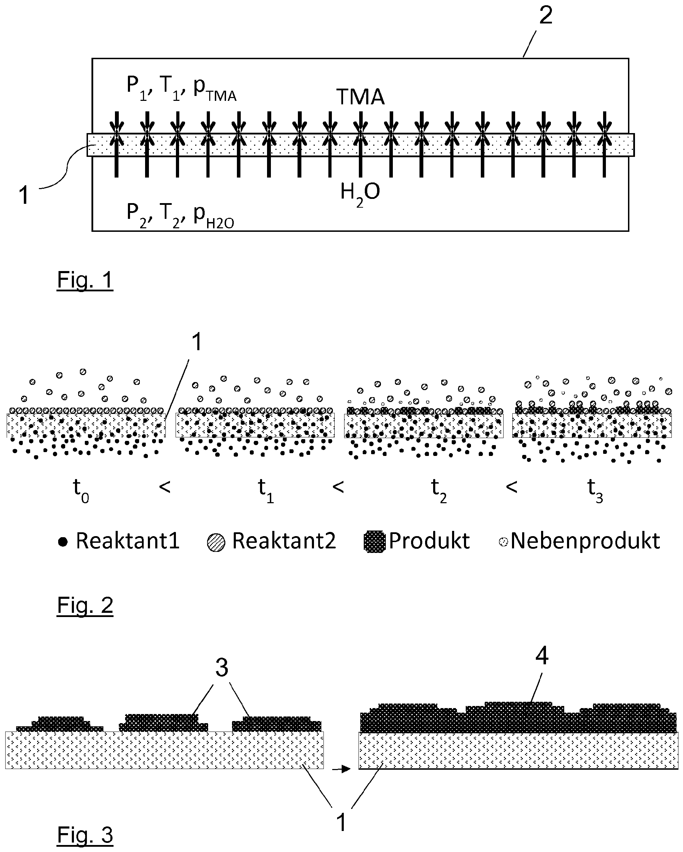

Figur 1 zeigt eine erste beispielhafte Anordnung zur Durchführung des Verfahrens, bei der eine Folie 1 in einem Reaktionsraum 2 angeordnet wird, den sie in zwei getrennte räumliche Bereiche separiert. Dem oberen Bereich wird in diesem Beispiel TMA in einem Trägergas zugeführt, dem unteren Bereich Wasserdampf ($H_2O$). $P_1$ und $P_2$ repräsentieren die Drücke im oberen und unteren Bereich, $T_1$, $T_2$ die entsprechenden Temperaturen und $p_{TMA}$ und $p_{H2O}$ repräsentieren die Partialdrücke. Typische Werte für diese Parameter wurden bereits weiter oben angeführt. Die Folie 1 ist hierbei für Wasser permeabel, so dass sie vom Wasserdampf durchdrungen werden kann, nicht jedoch von TMA, wie dies mit den Pfeilen in der Figur 1 angedeutet ist. Alle Polymermaterialien besitzen eine deutliche Durchlässigkeit für Wasser. Typischerweise liegen die Permeationsraten (WVTR bei 23°C, 85% rF, Materialdicke 100 $\mu$m) zwischen 0,1 und 100 g/m$^2$/d. Die Permeations- oder Transmissionsrate verhält sich umgekehrt proportional zur Materialdicke und proportional zum Wasserdampfpartialdruck und steigt exponentiell mit der Temperatur an. Durch die Wahl der Parameter kann die Permeationsrate innerhalb weiter Grenzen relativ einfach variiert werden.

Figur 2 zeigt hierzu beispielhaft den Verfahrensablauf zu unterschiedlichen Zeiten $t_0$ bis $t_3$. Im vorliegenden Beispiel permeiert nur Reaktant 1 ($H_2O$) durch die Folie 1. Reaktant 2 (TMA) adsorbiert an der Oberfläche der Folie 1 und reagiert dort mit dem durch die Folie 1 permeierten Reaktanten 1 zum Schichtmaterial (Produkt), wobei als Nebenprodukt in diesem Beispiel Methan entsteht.

Die Verwendung von Wasserdampf als Reaktant mit hoher Permeabilität und Trimethylaluminium (TMA) als Reaktant mit geringer Permeabilität durch Polymermaterial stellt ein Beispiel zur Anwendung des vorgeschlagenen Verfahrens dar. Es können auch andere Precursoren, die in ALD-, CVD- und MOCVD-Prozessen gebräuchlich sind, verwendet werden. Wird ein Reaktionspaar verwendet, das ungefähr gleiche Permeabilitäten in dem verwendeten Substrat aufweist, findet die Reaktion etwa in der Mitte des Substrats statt. Dies kann gegenüber der Schichtbildung an der Oberfläche Vorteile haben. Insbesondere wird dadurch mechanischer Abrieb der Schicht beim späteren Einsatz des Substrats vermieden.

Der Vorgang der Barriereausbildung läuft in folgender Weise ab. Auf einer Seite der Folie 1 wird z. B. TMA als Aluminium-Precursor zur Verfügung gestellt, auf der gegenüberliegenden Seite Wasserdampf. Die Temperatur und die Partialdrücke werden so eingestellt, dass der Prozess in der gewünschten Geschwindigkeit abläuft. Wassermoleküle wandern durch die Folie 1, bis sie auf der anderen Grenzfläche auf adsorbierte TMA-Moleküle treffen und mit diesen zu Aluminiumoxid (plus Methan) reagieren. Die TMA-Moleküle besitzen eine geringe Permeabilität in der Folie 1 und dringen daher kaum in tiefere Schichten des Polymers ein. Es bilden sich also mit fortschreitender Zeit AlO$_x$-Cluster 3 auf der Oberfläche der Folie 1 aus, wie dies schematisch in Figur 3 dargestellt ist. Die Clusterbildung erfolgt bevorzugt an den Stellen, an denen die Durchlässigkeit des Polymers für Wassermoleküle besonders hoch ist. Diese Cluster 3 haben aber eine geringere Permeabilität und bilden dadurch mit zunehmender Größe eine immer bessere Barriere für Wassermoleküle. In der Folge wachsen die Cluster 3 zu Inseln und schließlich zu einer geschlossenen Schicht 4 zusammen (vgl. Figur 3).

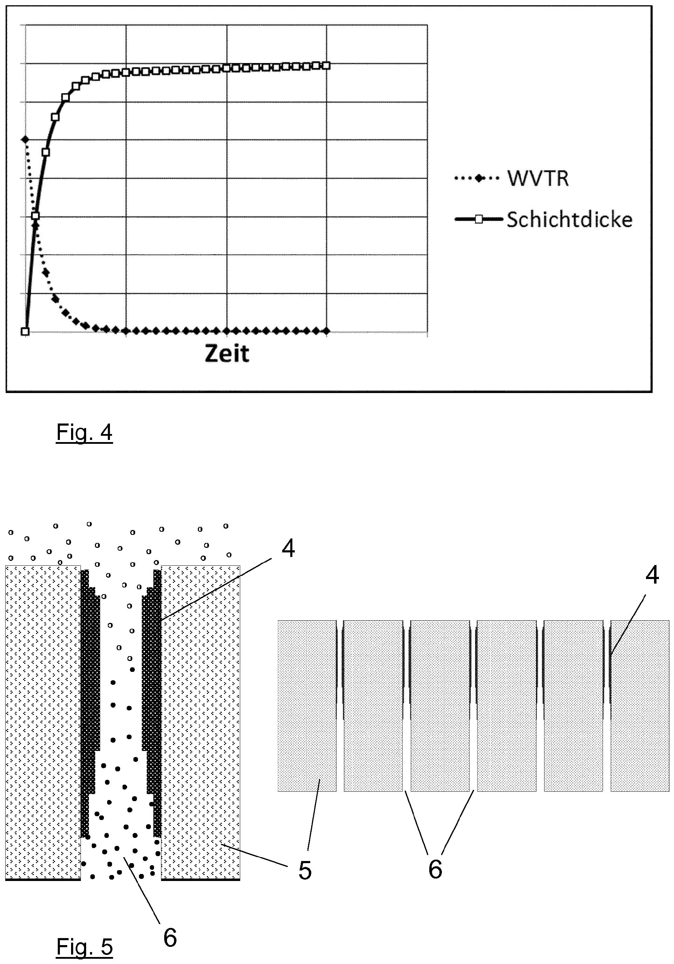

Die Geschwindigkeit des Schichtwachstums nimmt immer mehr ab, da immer weniger Wassermoleküle die Oberfläche und dort adsorbierte TMA-Moleküle erreichen. Dies ist schematisch in Figur 4 dargestellt, die einen schematischen Verlauf von Schichtwachstum und korrelierter Wasserdampf-Transmissionsrate zeigt. Der Prozess kann beendet werden, sobald die geforderte Wasserdampf-Transmissionsrate von z. B. 0,01 g/m$^2$/d erreicht ist.

Im Folgenden werden typische (anfängliche) Abscheideraten für ein System aus TMA und $H_2O$ abgeschätzt. Es wird eine WVTR von 10 g/m$^2$/d angenommen. Die benötigte Menge $H_2O$ für eine Monolage AlO$_x$ beträgt ungefähr

0,15 mg/m$^2$. Für das Lagenwachstum dn/dt gilt:

$$dn/dt = 10*1000/24/60 \; mg/m^2/min/0,15 \; mg/m^2$$
$$= 46 \; Monolagen/min.$$

Von der ALD ist bekannt, dass bereits ab etwa 50 Monolagen die Beschichtung eine ausgeprägte Barrierefunktion bildet. Bei der Gasphaseninfiltration ist dies im Vergleich schon bei ca. 20 Zyklen der Fall, was aber ca. 10 Minuten in Anspruch nimmt. Die notwendigen Prozesszeiten liegen also beim vorgeschlagenen Verfahren bereits bei relativ niedriger Wasserdampfpermeabilität des Substrates in einem für die industrielle Produktion geeigneten Bereich, insbesondere wenn (für einen hohen Durchsatz) lange, breite Folienbahnen behandelt werden. Viele Polymermaterialien weisen aber Permeationsraten auf, die um ein bis zwei Größenordnungen höher sind. Entsprechend kürzer werden für diese die Prozesszeiten und umso produktiver wird das Verfahren.

Das vorgeschlagene Verfahren eignet sich auch, um bereits auf Substraten vorhandene Barrierebeschichtungen zu verbessern, indem noch vorhandene Permeationspfade verschlossen werden. Bei Membranmaterialien können die Permeationseigenschaften durch Anwendung dieses Verfahrens ebenfalls verändert und an die Anwendung angepasst werden. Dies zeigt schematisch Figur 5, die im linken Teil schematisch einen Ausschnitt aus einer Membran 5 mit einem Permeationskanal 6 zeigt, der durch Zuführung der beiden Reaktanten von gegenüberliegenden Seiten der Membran durch Bildung einer Schicht 4 an den Innenwänden des Permeationskanals 6 verengt wird. Im rechten Teil der Figur ist ein anderer Ausschnitt aus der Membran 5 mit mehreren dieser durch die Schichtbildung gemäß dem vorgeschlagenen Verfahren verengten Permeationskanälen 6 zu erkennen.

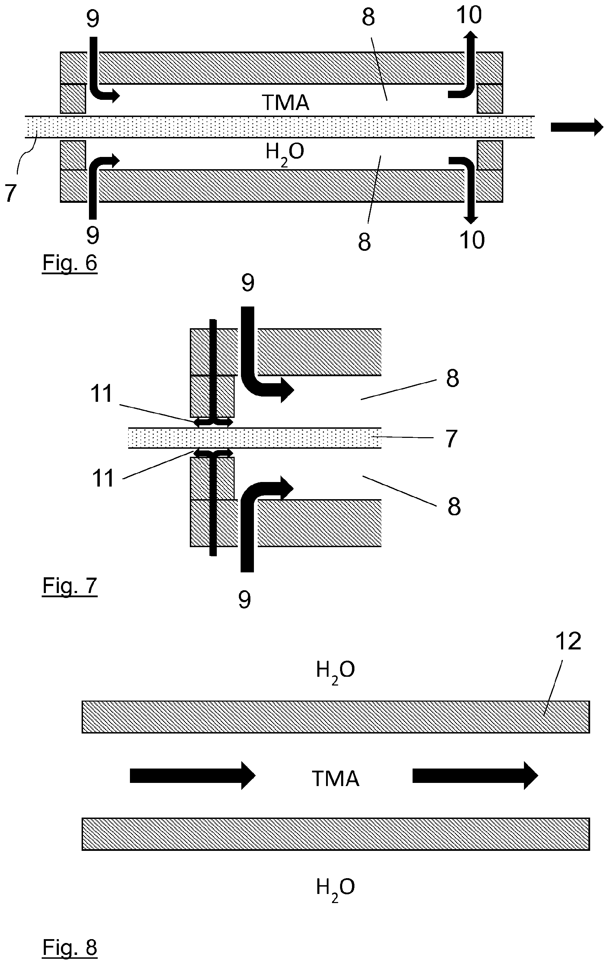

Das Verfahren kann in einem kontinuierlichen Produktionsprozess umgesetzt werden. Hierbei wird bspw. eine Folienbahn zwischen den beiden Reaktant-Zonen hindurchgeführt. Figur 6 zeigt hierzu beispielhaft eine Folienbahn 7, die zwischen den beiden Reaktant-Zonen 8 hindurchgeführt wird. Die Reaktanten werden mittels Trägergas über entsprechende Einlässe 9 diesen Zonen zugeführt und, zusammen mit gasförmigen Nebenprodukten, über Auslässe 10 wieder teilweise abgeführt, wie dies durch die gekrümmten Pfeile in der Figur 6 angedeutet ist. Die Folienbahn 7 wird hierbei in Pfeilrichtung durch diesen Reaktor mit den beiden Reaktant-Zonen gefördert. Der Reaktor ist so ausgebildet, dass die Auftrennung in die beiden Reaktant-Zonen 8 durch die Folienbahn 7 selbst erfolgt. Die Abschottung gegenüber der Umgebungsatmosphäre kann dabei bspw. über Inertgas-Vorhänge realisiert werden, wie sie im Ausschnitt der Anordnung der Figur 6 in Figur 7 beispielhaft dargestellt sind. Diese Gasvorhänge 11 werden über eine geeignete Zuführung von Inertgas realisiert wie dies in Figur 7 angedeutet ist.

Besonders einfach lässt sich auch eine Innenbeschichtung von Schläuchen realisieren, wie dies schematisch in Figur 8 dargestellt ist. Einer der beiden Reaktanten, im vorliegenden Fall das TMA, wird hierbei durch das Innere des Schlauches 12 geleitet, der von außen dem anderen Reaktanten, im vorliegenden Beispiel $H_2O$, ausgesetzt wird. Auf diese Weise kann eine Barrierebeschichtung aus Aluminiumoxid auf der Innenwand des Schlauches 12 erzeugt werden.

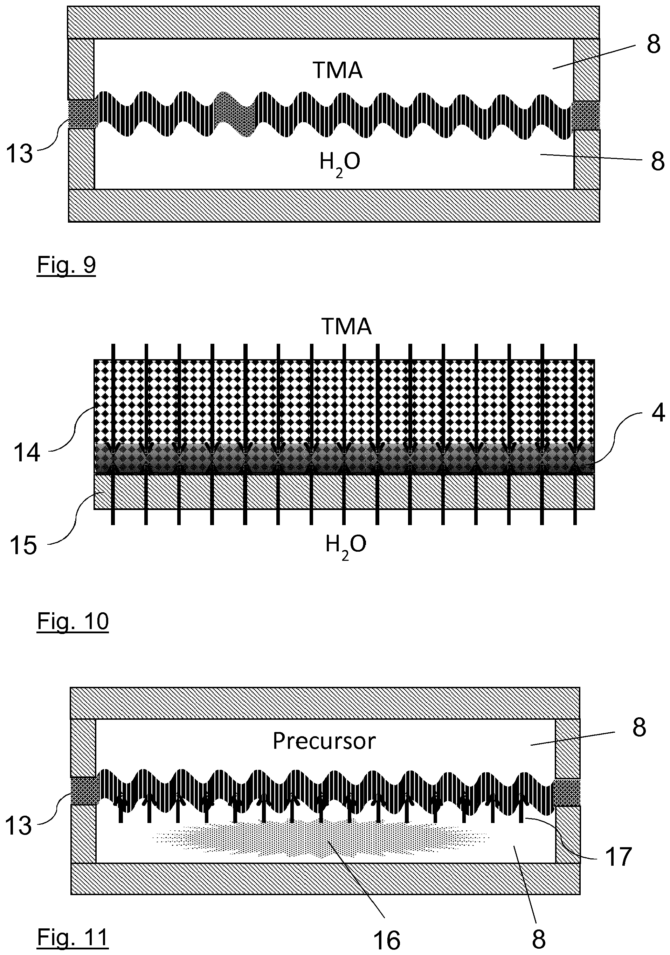

Das vorgeschlagene Verfahren kann auch auf Objekte mit komplexer 3D-Geometrie angewendet werden, wenn die Wände eine ausreichende Permeabilität für einen der beiden Reaktanten aufweisen und die zu beschichtende Oberfläche, bspw. eine Innenwand, gegenüber der restlichen Fläche (Außenwand) gastechnisch abgeschottet werden kann. Ein vereinfachtes Beispiel für ein dreidimensional geformtes Formteil 13, das mit dem vorgeschlagenen Verfahren beschichtet werden kann, ist in Figur 9 gezeigt. Dieses Formteil 13 wird wiederum in einen Reaktor gebracht, in dem durch das Formteil 13 zwei voneinander getrennte Reaktant-Zonen 8 gebildet werden. In der oberen Zone wird in diesem Beispiel TMA, in der unteren Zone $H_2O$ zugeführt. Auf diese Weise kann eine Beschichtung des Formteils 13 mit Aluminiumoxid realisiert werden.

Es können auch poröse Materialien wie Textilien oder Papier beschichtet bzw. funktionalisiert werden. Da diese Materialien eine Durchlässigkeit für viele gasförmige Stoffe aufweisen, wird im vorliegenden Beispiel eine Seite mit einer Schicht mit geeigneter Permeabilität für z.B. Wasserdampf, aufgebracht, die für den anderen Reaktanten nicht durchlässig ist. Dies kann z.B. eine permanente Polymerbeschichtung sein oder auch eine Folie, die nur für den Prozess notwendig ist und später entfernt wird. Ist eine derartige Schicht bereits auf der Textilie oder dem Papier aus anderen Gründen vorhanden, so ist die zusätzliche Schicht dann nicht mehr notwendig. Figur 10 zeigt hierzu ein Beispiel, bei dem auf eine Textilie oder ein Papier 14 eine entsprechend ablösbare Folie oder Polymerbeschichtung 15 aufgebracht ist, die für $H_2O$ permeabel ist. Durch entsprechende Zufuhr von TMA und $H_2O$ von beiden Seiten wird dann mit dem vorgeschlagenen Verfahren eine Beschichtung an der Oberfläche der Textilie bzw. des Papiers 14 realisiert.

Das Verfahren ist nicht auf rein thermisch aktivierte Reaktionen beschränkt. Es können vielmehr - wie bei der ALD und der CVD - durch Erzeugung von Plasmen in den Prozessräumen auch Ionen oder Radikale zum Prozess beitragen, wie dies schematisch mit dem Plasma 16 in Figur 11 dargestellt ist. In diesem Beispiel befindet sich ein Formteil 13 in dem Reaktor mit den beiden Reaktor-Zonen 8, wobei in der unteren Reaktor-Zone ein Plasma 16 gezündet wird, durch das Ionen und Radikale 17 ebenfalls auf den Beschichtungsprozess einwirken. Diese wandern durch das Substrat und reagieren mit dem auf der gegenüberliegenden Oberfläche adsorbierten Precursor.

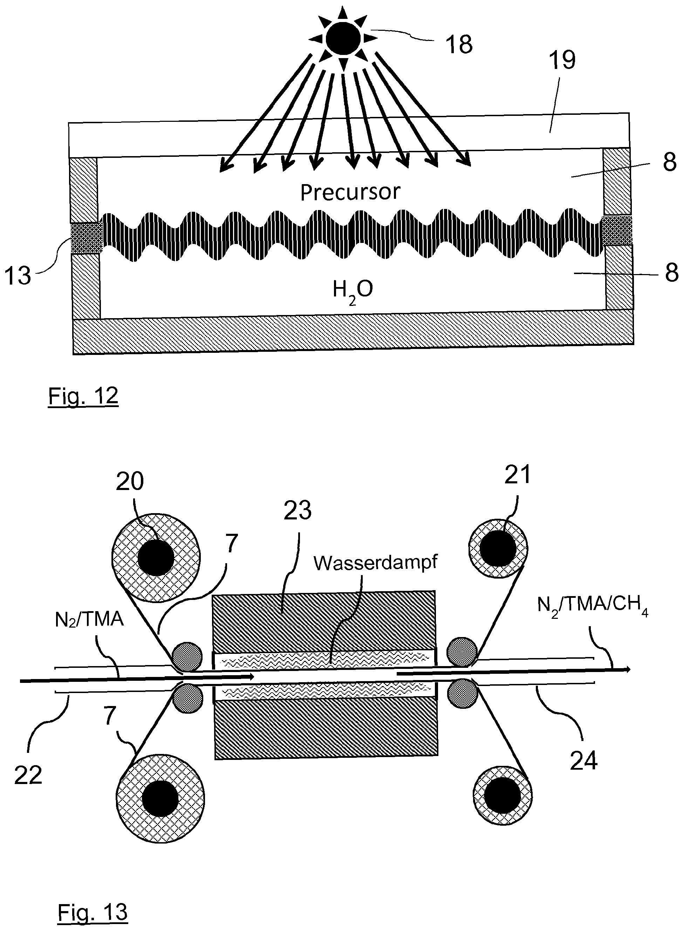

Auch eine Aktivierung der Reaktion durch Einkopplung von Photonen ist möglich, wie dies schematisch in Figur 12 dargestellt ist. In diesem Fall wird eine der Reaktorwände für die entsprechende elektromagnetische Strahlung durchlässig ausgeführt, so dass diese Strahlung ebenfalls mit dem auf dem Substrat adsorbierten Prekursor wechselwirken kann. Figur 12 zeigt hierzu eine Lichtquelle 18 (UV, VIS und/oder IR) und ein auf dieser Seite der Lichtquelle vorhandenes optisch transparentes Fenster 19 zur Einkopplung der optischen Strahlung.

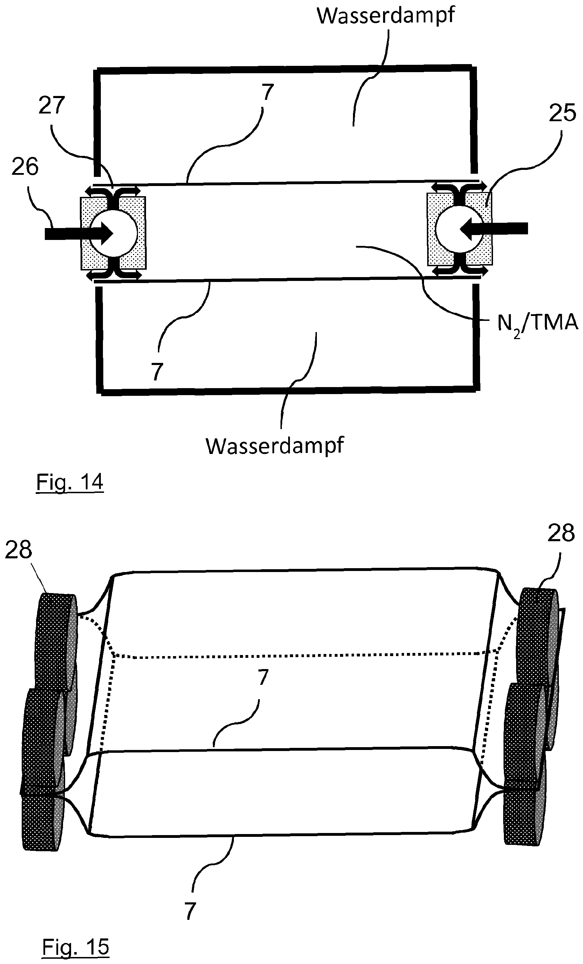

Figur 13 zeigt eine beispielhafte Anordnung zur gleichzeitigen Behandlung von zwei Folienbahnen in einem kontinuierlichen Rolle-zu-Rolle-Verfahren. Die beiden Folienbahnen 7 werden hierbei von zwei Abwickelrollen 20 abgewickelt, über Umlenkrollen 32 durch einen Reaktionsraum geführt und nach der Beschichtung über entsprechende Aufwickelrollen 21 wieder aufgewickelt. Die Folienbahnen 7 werden dabei übereinander mit einem definierten Zwischenraum durch den Reaktionsraum gefördert, wie dies in Figur 13 zu erkennen ist. Über eine Flachdüse 22 wird in den Zwischenraum zwischen den beiden Folienbahnen 7 einer der Reaktanten, im vorliegenden Fall TMA in einem $N_2$-Trägergas, zugeführt. Im Reaktionsraum befindet sich Wasserdampf, der durch eine entsprechende Heizung 23 auf einer konstanten Temperatur gehalten wird. Das Trägergas mit dem restlichen TMA und dem bei der Reaktion entstehenden Nebenprodukt ($CH_4$) wird an der gegenüberliegenden Seite des Reaktionsraums über eine entsprechende weitere Flachdüse 24 wieder aus dem Zwischenraum abgesaugt. Für diese Anordnung muss der Zwischenraum zwischen den beiden übereinanderliegenden Folienbahnen 7 geeignet seitlich abgedichtet werden, um eine Vermischung der beiden Reaktanten im Reaktionsraum zu verhindern. Dies kann auf unterschiedliche Weise erfolgen, wie in den folgenden Figuren 14 bis 17 in unterschiedlichen Varianten beispielhaft dargestellt ist.

Während Figur 13 einen Schnitt längs der Folienbahnen 7 zeigt, ist in Figur 14 ein Schnitt quer zu den Folienbahnen 7 in einer Variante der Anordnung dargestellt. Die beiden Folien werden hierbei auf entsprechenden Führungsschienen 25 geführt, die in diesem Beispiel einen innen liegenden Kanal mit nach oben und unten offenen Austrittsschlitzen aufweisen, in dem Inertgas 26 geführt wird. Das Inertgas 26 bildet hierbei durch den Austritt aus den Austrittsschlitzen ein Inertgas-Polster 27 zwischen der jeweiligen Folienbahn 7 und der Führungsschiene 25. Dadurch wird der Zwischenraum zwischen den beiden Folienbahnen 7 seitlich so abgedichtet, dass kein Reaktant austreten kann.

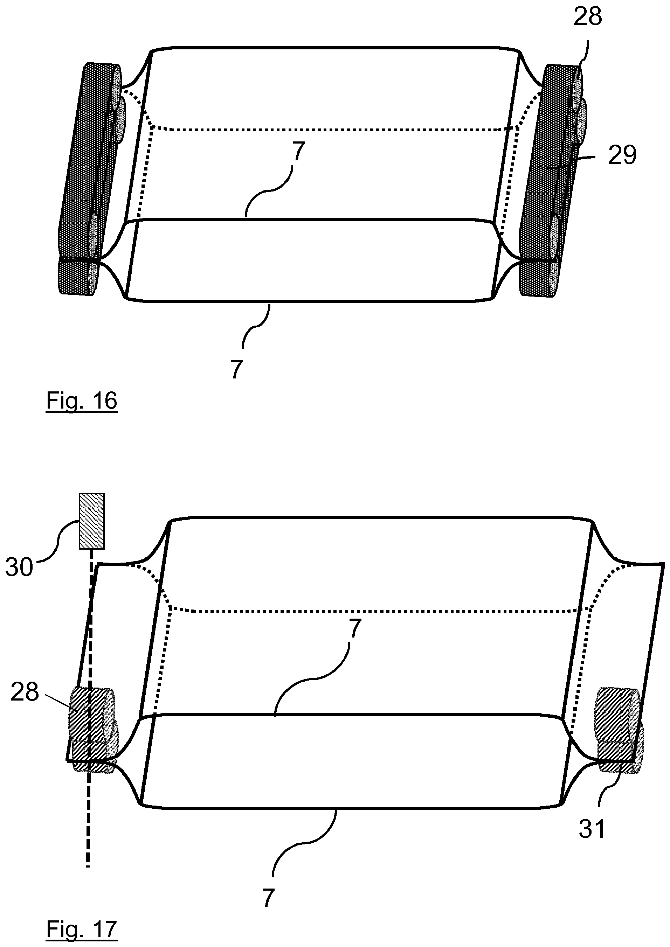

Die seitliche Abdichtung kann in einer anderen Ausgestaltung auch durch ein Zusammendrücken der Folienbahnen 7 an den seitlichen Rändern erfolgen, wie dies schematisch in Figur 15 dargestellt ist. Die beiden Folienbahnen 7 werden hierbei durch geeignete Rollen 28 zusammengedrückt, um ein seitliches Austreten des Reaktanten aus dem Zwischenraum zwischen den beiden Folienbahnen 7 zu verhindern. Anstelle einzelner Rollen können auch entsprechende, über Rollen 28 geführte Bänder 29 für das seitliche Zusammendrücken der beiden Folienbahnen 7 genutzt werden, wie dies in Figur 16 beispielhaft dargestellt ist.

Eine weitere Möglichkeit der seitlichen Abdichtung besteht darin, eine temporäre Siegelnaht herzustellen, die nach dem Beschichten und vor dem Aufwickeln der beiden Folienbahnen 7 wieder aufgetrennt wird. Dies ist beispielhaft in Figur 17 darstellt, bei der die temporäre Siegelnaht zur seitlichen Verbindung der beiden Folienbahnen 7 durch Zusammendrücken der Folienbahnen mit zwei Rollen 28 und anschließende Erwärmung mit einem Laser 30 realisiert wird (linker Teil der Figur 17). Alternativ können auch zwei geheizte Rollen 31 zur Erzeugung der Siegelnaht verwendet werden, wie dies im rechten Teil der Figur 17 schematisch dargestellt ist.

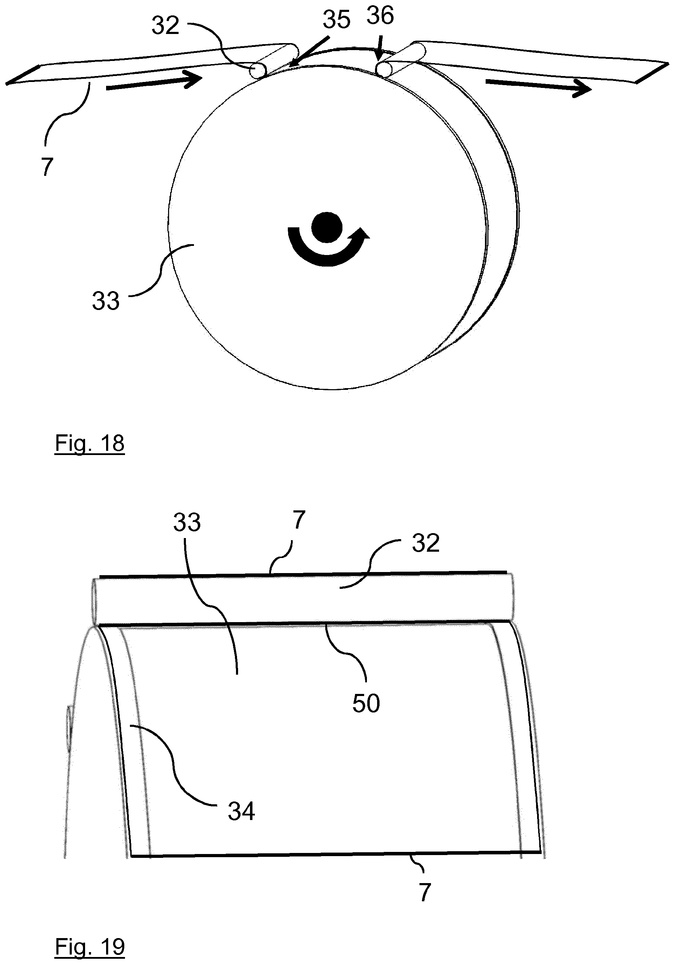

Die Figuren 18 und 19 zeigen schematisch eine weitere Ausgestaltung einer Anordnung zur Behandlung bzw. Beschichtung einer Folie gemäß dem vorgeschlagenen Verfahren. In diesem Beispiel läuft die Folienbahn 7 über eine Umlenkrolle 32 um eine drehbar gelagerte Trommel 33 und wird nach nahezu vollständigem Umlaufen um die Trommel 33 wieder über eine Umlenkrolle 32 entsprechend den angedeuteten Pfeilen weiter gefördert. Die Trommel 33 weist hierbei eine strukturierte Umlauffläche mit zwei auf beiden Seiten umlaufenden Stegen 34 auf, wie dies in der vergrößerten Darstellung in Figur 19 zu erkennen ist. Durch die beidseitigen Stege 34 und die sich bis über diese Stege 34 erstreckende Folienbahn 7 entsteht ein Zwischenraum 50 zwischen der Folienbahn 7 und der Umlauffläche der Trommel 33 zwischen den Stegen. In diesen Zwischenraum 50 wird ein Prozessgas mit einem der beiden Reaktanten eingespeist, wie dies mit dem Bezugszeichen 35 in der Figur 18 angedeutet ist. Das Prozessgas wird dann auf der gegenüberliegenden Seite entsprechend den Bezugszeichen 36 wieder abgesaugt. Der Transport der Folienbahn 7 entlang der unter der Folienbahn angedeuteten Pfeile erfolgt bei dieser Ausgestaltung durch Drehung der Trommel 33. Die Trommel 33 befindet sich hierbei wiederum mit einem Abschnitt in einem Reaktionsraum (in der Figur nicht dargestellt), in dem der zweite Reaktant vorhanden ist.

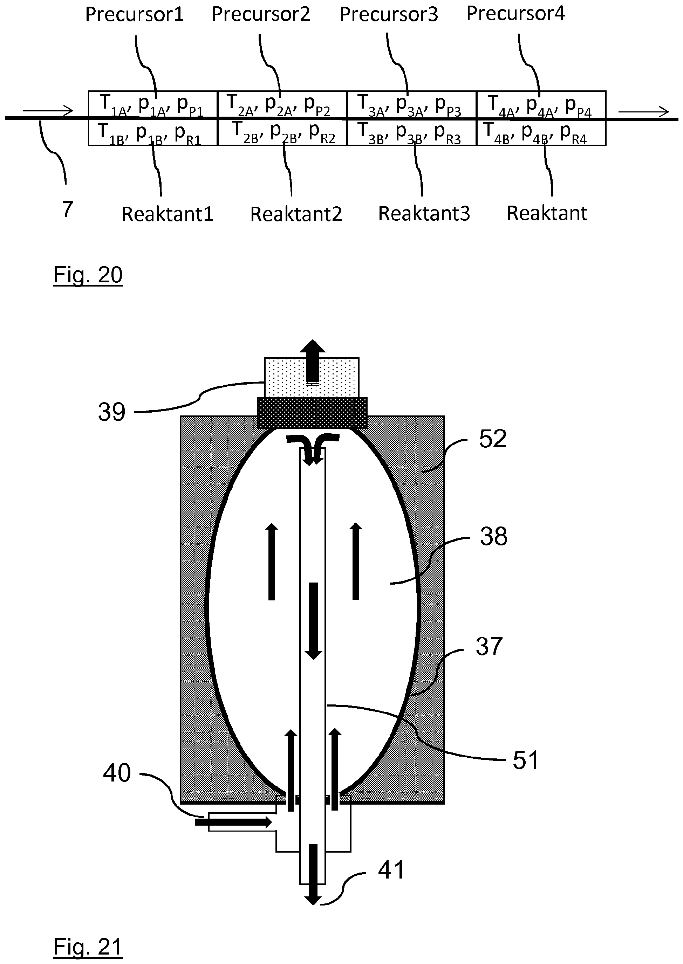

Bei dem vorgeschlagenen Verfahren wird bei geeigneter Wahl der Reaktanten/Precursoren und Verfahrensparameter zur Bildung permeabler Schichten auch ermöglicht, mehrere Schichten aus unterschiedlichen Materialien übereinander aufzubringen. Dies kann durch sequentielle Anordnung von mehreren Beschichtungsmodulen erfolgen, wie dies beispielhaft in Figur 20 mit vier Modulen dargestellt ist, in denen jeweils andere Reaktanten- bzw. Reaktant-Precursor-Paare genutzt werden. Die in der Figur in den einzelnen Reaktanten-Zonen (x = 1 - 4) dargestellten Parameter bedeuten:

$T_{xA}$:    Temperatur in Precursor-Zone x

$T_{xB}$:   Temperatur in Reaktant-Zone x

$p_{xA}$:   Gesamtdruck in Precursor-Zone x

$p_{xB}$:   Gesamtdruck in Reaktant-Zone x

$p_{Px}$:   Partialdruck Precursor x

$P_{Rx}$:   Partialdruck Reaktant x

Figur 21 zeigt eine weitere Möglichkeit einer Beschichtung von Schlauchfolien mit dem vorgeschlagenen Verfahren. Bei der in der Figur dargestellten Anordnung werden die Schlauchfolien direkt während der Blasfolienextrusion beschichtet. Die Figur zeigt hierbei einen Reaktionsraum, in den die Blasfolie 37 unter Bildung einer Blase 38 aufgeblasen und am Austritt dieses Reaktionsraums dann als flachgelegte Schlauchfolie 39 der Aufwicklung zugeführt wird. In der vorgeschlagenen Anordnung wird in die Blasfolie 37 über eine geeignet angeordnete Einspeisung 40 Prozessgas, im vorliegenden Fall trockene Luft mit dem Precursor, über eine ringförmige Öffnung eingeleitet. Außerhalb der Blase 38 befindet sich im Reaktionsraum eine kontrollierte Atmosphäre mit Wasserdampf 52 oder einem anderen Reaktanten. Auf diese Weise erfolgt gemäß dem vorgeschlagenen Verfahren eine Beschichtung der Blasfolie 37 an der Innenwandung. Der nicht verbrauchte Precursor wird mit dem Prozessgas und den entstandenen Nebenprodukten über das Rohr 51 und eine entsprechende Abführung 41 wieder abgezogen.

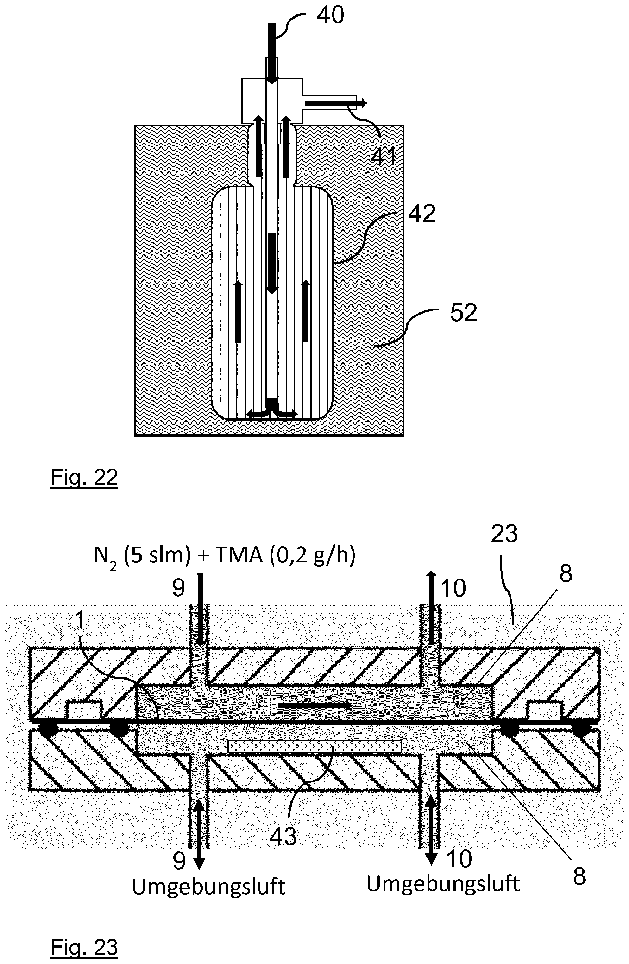

Figur 22 zeigt schließlich ein Beispiel einer Anordnung zur Beschichtung von Kunststoffbehältern. In diesem Beispiel wird eine Kunststoff-Flasche 42 in den Reaktionsraum gebracht und an ihrer Verschlussseite mit einem Anschluss für die Einspeisung 40 eines Prozessgases und die Abführung 41 des Prozessgases verbunden, wie dies in der Figur 22 schematisch dargestellt ist. Der Reaktionsraum stellt in diesem Beispiel einen Ofen mit kontrollierter Atmosphäre dar, in dem beispielsweise Wasserdampf 52 oder ein anderer Reaktant vorhanden ist. Auf diese Weise erfolgt wiederum die Beschichtung der Innenseite der Kunststoff-Flasche 42 gemäß dem vorgeschlagenen Verfahren.

Figur 23 zeigt schließlich noch einen schematischen Versuchsaufbau, mit dem Versuche mit unterschiedlichen Verfahrensparametern durchgeführt wurden. Der Versuchsaufbau umfasst wiederum einen Reaktionsraum, der durch Einlegen einer zu beschichtenden Folie 1 in zwei Reaktant-Zonen 8 unterteilt wird. Die obere Zone und die untere Zone weisen hierbei jeweils einen Einlass 9 und einen Auslass 10 für die Zufuhr und den Ablass der jeweiligen Prozessgase auf. Im vorliegenden Beispiel wurde der oberen Reaktant-Zone jeweils für 15 Minuten $N_2$ (5 slm) als Trägergas mit TMA (0,2 g/h) zugeführt. In der unteren Reaktant-Zone befindet sich bei den ersten beiden Beispielen ein Feuchtereservoir 43, um in Verbindung mit der zugeführten Umgebungsluft einen entsprechenden Wassergehalt in der Umgebungsluft zu erzeugen. Die Anordnung wird über eine Heizung 23 temperiert. Für die Versuche wurde eine Folie 1 aus PET mit einer Dicke von 100 $\mu$m eingesetzt. Hierbei zeigt es sich, dass bei einer Temperatur von 22°C und einer Luftfeuchte in der unteren Reaktant-Zone von > 95% rF (Beispiel 1) eine Schicht aus Aluminiumoxid auf der Folie gebildet wurde, die eine Dicke von 190 nm aufwies. Bei der gleichen Luftfeuchte und einer Temperatur von 50°C (Beispiel 2) bildete sich eine Schicht aus Aluminiumoxid von ca. 620 nm. Wurde das Feuchtereservoir nicht verwendet, entsprach der Wasserdampfpartialdruck in der unteren Reaktant-Zone dem der Umgebungsluft, bei den vorliegenden Beispielen ungefähr 8 mbar. Bei einer Einstellung der Temperatur auf 85°C (Beispiel 3) bildete sich bei diesem Wasserdampfpartialdruck lediglich eine Schichtdicke der Aluminiumoxidschicht von ca. 95 nm. Bei noch stärkerer Erhöhung der Temperatur auf 110°C (Beispiel 4) wurde bei gleichem Wasserdampfpartialdruck lediglich noch eine Dicke der Aluminiumoxidschicht von ca. 30 nm gemessen, wobei allerdings chemische Reaktionen des Polymermaterials mit dem TMA beobachtet wurden. Somit zeigte sich durch diese Versuche, dass sich mit dem Verfahren auch praktisch beliebig dicke Schichten erzeugen lassen, wenn die Parameter so gewählt werden, dass die abgeschiedene Schicht eine hohe Permeabilität für Wasserdampf (oder andere mögliche Reaktanten) aufweist. Nur in den beiden letztgenannten Beispielen 3 und 4 hatten die Aluminiumoxidschichten eine Barrierewirkung gegenüber Wasserdampf. Die niedrigsten Permeationswerte hatte die Schicht im dritten Beispiel mit WVTR = 0,1 g/m$^2$/d (bei 23°C/85% rF), OTR = 0,05 cm$^3$ (stp)/m$^2$/d/bar.

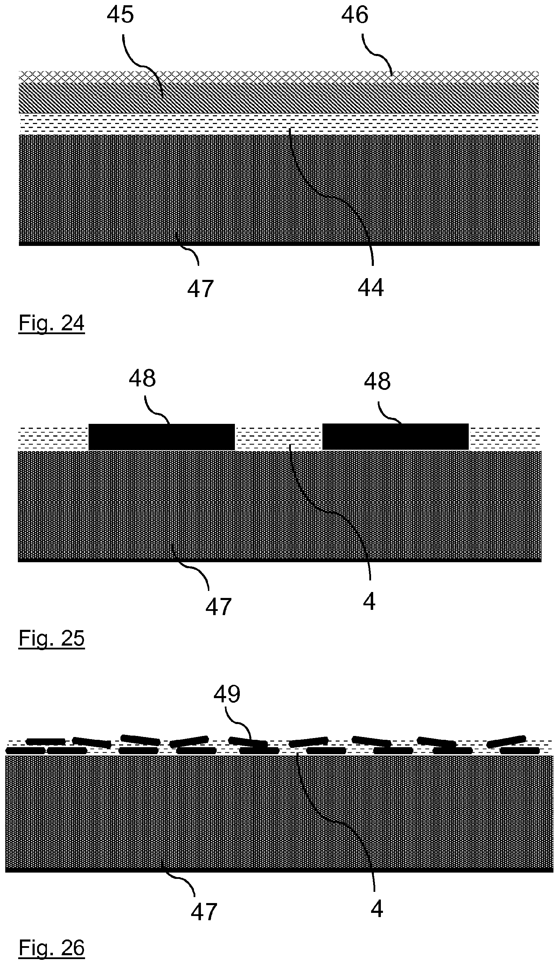

Je nach Wahl der Parameter und Reaktanten kann damit entweder eine Barriereschicht mit Barrierewirkung gegenüber dem Reaktanten wie z.B. Wasserdampf ausgebildet werden oder auch eine nahezu beliebig dicke Schicht oder ein Schichtsystem aus unterschiedlichen Materialien. Figur 24 zeigt hierbei ein Beispiel eines Schichtsystems bestehend aus drei Schichten 44 bis 46 aus unterschiedlichen Materialien auf einem Polymersubstrat 47. Das Aufbringen dieser Schichten erfordert, dass zumindest die unteren beiden Schichten 44, 45 permeabel gegenüber dem Reaktanten wie beispielsweise Wasserdampf sind.

Da die Beschichtung nicht an Stellen wächst, an denen ein impermeables Material auf dem Substrat vorhanden ist, können Schichten selektiv zwischen Bereichen mit dem impermeablen Material, beispielsweise zwischen metallischen Leiterbahnen, abgeschieden werden. Figur 25 zeigt hierzu beispielsweise ein Polymersubstrat 47 mit entsprechenden Strukturen 48 aus einem nicht permeablen Material. Bei der Durchführung des vorgeschlagenen Verfahrens mit einem derartigen Substrat findet der Schichtaufbau nur zwischen diesen Strukturen 48 statt, wie in Figur 25 mit den entsprechenden lokalen Schichten 4 angedeutet ist.

Mit dem vorgeschlagenen Verfahren lassen sich auch vorher auf das Substrat aufgebrachte Partikel einbetten, beispielsweise Kohlenstoff-Nanoröhrchen (CNT), Graphen oder Quantenpunkte. Figur 26 zeigt hierzu eine schematische Darstellung, in der mit dem vorliegenden Verfahren auf einem Polymersubstrat 47 aufgebrachte Partikel 49 in die Schicht 4 eingebettet werden.

Bezugszeichenliste

| | |
|---|---|
| 1 | Folie |
| 2 | Reaktionsraum |
| 3 | Cluster |
| 4 | Schicht |
| 5 | Membran |
| 6 | Permeationskanal |
| 7 | Folienbahn |
| 8 | Reaktant-Zone |
| 9 | Einlass |
| 10 | Auslass |
| 11 | Gasvorhang |
| 12 | Schlauch |
| 13 | Formteil |
| 14 | Textilie/Papier |
| 15 | Folie/Polymerbeschichtung |
| 16 | Plasma |
| 17 | Ionen/Radikale |
| 18 | Lichtquelle |
| 19 | Optisch transparentes Fenster |
| 20 | Abwickelrolle |
| 21 | Aufwickelrolle |
| 22 | Flachdüse (Zufuhr) |
| 23 | Heizung |
| 24 | Flachdüse (Absaugung) |
| 25 | Führungsschiene |
| 26 | Inertgas |
| 27 | Inertgas-Polster |
| 28 | Rolle |
| 29 | Band |
| 30 | Laser |
| 31 | beheizte Rolle |
| 32 | Umlenkrolle |
| 33 | Trommel |
| 34 | Steg |
| 35 | Einspeisung Prozessgas |
| 36 | Absaugung Prozessgas |
| 37 | Blasfolie |
| 38 | Blase |
| 39 | Schlauchfolie |
| 40 | Einspeisung |
| 41 | Abführung |
| 42 | Kunststoff-Flasche |
| 43 | Feuchtereservoir |
| 44 | Schicht |
| 45 | Schicht |
| 46 | Schicht |
| 47 | Polymersubstrat |
| 48 | impermeable Struktur |
| 49 | Partikel |
| 50 | Zwischenraum |
| 51 | Rohr |

52    Atmosphäre mit Wasserdampf

**Patentansprüche**

1.  Verfahren zur Bildung einer Schicht (4) oder einzelner Cluster (3) eines Materials durch chemische Reaktion von wenigstens zwei Reaktanten an und/oder unter einer Oberfläche eines Substrats (1), das für einen der Reaktanten permeabel ist,
    **dadurch gekennzeichnet,**
    **dass** die wenigstens zwei Reaktanten von gegenüberliegenden Seiten der Oberfläche des Substrats (1) zugeführt werden, indem entweder die wenigstens zwei Reaktanten durch das Substrat (1) voneinander getrennt von gegenüberliegenden Seiten des Substrats (1) zugeführt werden oder einer der zwei Reaktanten vor der Zuführung des anderen Reaktanten in dem Substrat gelöst oder angereichert wird.

2.  Verfahren nach Anspruch 1,
    **dadurch gekennzeichnet,**
    **dass** als Substrat (1) eine Polymerfolie eingesetzt wird.

3.  Verfahren nach Anspruch 1 oder 2,
    **dadurch gekennzeichnet,**
    **dass** als Substrat (1) eine Membran (5) eingesetzt wird, bei der die Bildung der Schicht (4) und/oder Cluster (3) an Innenwandungen von Permeationskanälen (6) erfolgt, um Permeationseigenschaften der Membran (5) zu verändern.

4.  Verfahren nach Anspruch 1,
    **dadurch gekennzeichnet,**
    **dass** für eine Beschichtung einer Oberfläche eines für beide Reaktanten permeablen Substrats (1), insbesondere von Textilien oder Papier (14), zunächst eine nur für einen der beiden Reaktanten permeable Folie (15) auf das Substrat (1) aufgebracht und nach Bildung der Schicht wieder entfernt wird.

5.  Verfahren nach einem der Ansprüche 2 bis 4,
    **dadurch gekennzeichnet,**
    **dass** das Substrat (1) als Materialbahn (7) durch einen Reaktionsraum (2) geführt wird, der durch die Materialbahn (7) in zwei getrennte Teilräume (8) aufgetrennt wird, denen die wenigstens zwei Reaktanten zugeführt werden.

6.  Verfahren nach einem der Ansprüche 2 bis 4,
    **dadurch gekennzeichnet,**
    **dass** zwei Substrate (1) als übereinander liegende Materialbahnen (7), die durch einen seitlich abgeschlossenen Zwischenraum voneinander beabstandet sind, durch einen Reaktionsraum geführt werden, wobei einer der wenigstens zwei Reaktanten dem Zwischenraum zwischen den beiden Materialbahnen (7) und der andere dem Reaktionsraum zugeführt wird.

7.  Verfahren nach Anspruch 1,
    **dadurch gekennzeichnet,**
    **dass** ein Schlauch (12), eine Schlauchfolie oder ein Hohlkörper (42) als Substrat (1) eingesetzt wird.

8.  Verfahren nach Anspruch 1,
    **dadurch gekennzeichnet,**
    **dass** eine durch Schlauchfolienextrusion hergestellte Schlauchfolie (39) als Substrat (1) eingesetzt wird, die während der Schlauchfolienextrusion beschichtet wird, indem einer der Reaktanten in eine während der Schlauchfolienextrusion gebildete Blase (38) eingeführt wird, während sich die Blase (38) in einem mit dem anderen Reaktanten gefüllten Reaktionsraum befindet.

9.  Verfahren nach einem der Ansprüche 1 bis 8,
    **dadurch gekennzeichnet,**
    **dass** die Reaktanten in gas- oder dampfförmigem Zustand zugeführt werden.

10. Verfahren nach einem der Ansprüche 1 bis 9,

**dadurch gekennzeichnet,**
**dass** als einer der Reaktanten Wasser oder Wasserdampf eingesetzt wird.

11. Verfahren nach einem der Ansprüche 1 bis 10,
**dadurch gekennzeichnet,**
**dass** als Reaktanten Substanzen für die Bildung der Schicht (4) und/oder Cluster (3) aus einem Barrierematerial, insbesondere als Barriere für Wasserdampf, Sauerstoff und/oder Kohlendioxid, eingesetzt werden.

12. Verfahren nach einem der Ansprüche 1 bis 11 zur Erzeugung von Nanopartikeln oder Quantenpunkten in und/oder auf dem Substrat (1).

13. Verfahren nach einem der Ansprüche 1 bis 11, bei dem durch Wechsel der Reaktanten nacheinander mehrere der Schichten (4) aus unterschiedlichen Materialien auf dem Substrat (1) gebildet werden.

14. Verfahren nach einem der Ansprüche 1 bis 13 zur Beschichtung von Zwischenräumen zwischen nicht permeablen Strukturen (48) auf dem Substrat (1).

15. Verfahren nach einem der Ansprüche 1 bis 14 zur Einbettung anorganischer oder organischer Partikel (49), die vor der Bildung der Schicht (4) auf das Substrat (1) aufgebracht werden.

16. Verfahren nach einem der Ansprüche 1 bis 15,
**dadurch gekennzeichnet,**
**dass** die chemische Reaktion thermisch und/oder mittels Plasma und/oder durch Bestrahlung aktiviert wird.

17. Substrat mit einer Oberflächenbeschichtung, die mit dem Verfahren nach einem oder mehreren der vorangehenden Patentansprüche aufgebracht wurde.

18. Substrat nach Anspruch 17,
**dadurch gekennzeichnet,**
**dass** das Substrat eine Folie, insbesondere eine Polymerfolie, ist.

19. Substrat nach Anspruch 17 oder 18,
**dadurch gekennzeichnet,**
**dass** die Oberflächenbeschichtung als Barriereschicht für Wasserdampf und/oder Sauerstoff und/oder Kohlendioxid ausgebildet ist.

$P_1$, $T_1$, $p_{TMA}$      TMA

$H_2O$

$P_2$, $T_2$, $p_{H2O}$

Fig. 1

$t_0$    <    $t_1$    <    $t_2$    <    $t_3$

● Reaktant1    ⊘ Reaktant2    ▓ Produkt    ⊙ Nebenprodukt

Fig. 2

Fig. 3

Fig. 4

Fig. 5

9     8  10

TMA

$H_2O$

7

9     8  10

<u>Fig. 6</u>

9

11

7

11

8

8

<u>Fig. 7</u>

9

12

$H_2O$

TMA

$H_2O$

<u>Fig. 8</u>

Fig. 9

Fig. 10

Fig. 11

Fig. 12

Fig. 13

Fig. 14

Fig. 15

Fig. 16

Fig. 17

Fig. 18

Fig. 19

Precursor1　　Precursor2　　Precursor3　　Precursor4

| $T_{1A}, p_{1A}, p_{P1}$ | $T_{2A}, p_{2A}, p_{P2}$ | $T_{3A}, p_{3A}, p_{P3}$ | $T_{4A}, p_{4A}, p_{P4}$ |
|---|---|---|---|
| $T_{1B}, p_{1B}, p_{R1}$ | $T_{2B}, p_{2B}, p_{R2}$ | $T_{3B}, p_{3B}, p_{R3}$ | $T_{4B}, p_{4B}, p_{R4}$ |

7

Reaktant1　　Reaktant2　　Reaktant3　　Reaktant

Fig. 20

39

52

38

37

51

40

41

Fig. 21

Fig. 22

N$_2$ (5 slm) + TMA (0,2 g/h)

Umgebungsluft    Umgebungsluft

Fig. 23

45    46

47    44

Fig. 24

48    48

47    4

Fig. 25

49

47    4

Fig. 26

**Europäisches Patentamt**
**European Patent Office**
**Office européen des brevets**

# EUROPÄISCHER RECHERCHENBERICHT

**Nummer der Anmeldung**

EP 19 20 4513

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | COLLEN Z. LENG ET AL: "Vapor phase infiltration (VPI) for transforming polymers into organic-inorganic hybrid materials: a critical review of current progress and future challenges", MATER. HORIZ., Bd. 4, Nr. 5, 1. Januar 2017 (2017-01-01), Seiten 747-771, XP055543242, ISSN: 2051-6347, DOI: 10.1039/C7MH00196G * das ganze Dokument * | 17-19 | INV. C23C16/54 C23C16/455 C23C16/04 B01D67/00 C23C16/44 |
| X | US 2014/037853 A1 (LEE SANG IN [US]) 6. Februar 2014 (2014-02-06) * Absatz [0041] - Absatz [0047]; Abbildungen 1,2 * | 1-3,5-9, 11,14-16 | |
| X | NAKAO S-I ET AL: "Preparation of microporous membranes by TEOS/O"3 CVD in the opposing reactants geometry", MICROPOROUS AND MESOPOROUS MATERIALS, ELSEVIER, AMSTERDAM, NL, Bd. 37, Nr. 1-2, 1. Mai 2000 (2000-05-01), Seiten 145-152, XP004196667, ISSN: 1387-1811, DOI: 10.1016/S1387-1811(99)00261-9 * Abbildung 1 * | 1 | |
| | | | **RECHERCHIERTE SACHGEBIETE (IPC)** C23C B01D |
| X | US 1 685 759 A (HANS WALTER) 25. September 1928 (1928-09-25) * Seite 1, Zeile 85 - Zeile 95; Abbildung 1 * | 1 | |
| A | DE 10 2012 109251 A1 (OSRAM GMBH [DE]) 3. April 2014 (2014-04-03) * Abbildung 7 * | 6-8 | |
| A | WO 2016/205242 A1 (ALD NANOSOLUTIONS INC [US]) 22. Dezember 2016 (2016-12-22) * Abbildung 4 * | 15 | |

Der vorliegende Recherchenbericht wurde für alle Patentansprüche erstellt

| Recherchenort | Abschlußdatum der Recherche | Prüfer |
|---|---|---|
| Den Haag | 2. März 2020 | Schuhmacher, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

EP 3 643 809 A1

**ANHANG ZUM EUROPÄISCHEN RECHERCHENBERICHT
ÜBER DIE EUROPÄISCHE PATENTANMELDUNG NR.**

EP 19 20 4513

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-03-2020

| Im Recherchenbericht angeführtes Patentdokument | Datum der Veröffentlichung | Mitglied(er) der Patentfamilie | Datum der Veröffentlichung |
|---|---|---|---|
| US 2014037853 A1 | 06-02-2014 | KEINE | |
| US 1685759 A | 25-09-1928 | KEINE | |
| DE 102012109251 A1 | 03-04-2014 | DE 102012109251 A1<br>JP 2015535887 A<br>US 2015275373 A1<br>WO 2014049020 A2 | 03-04-2014<br>17-12-2015<br>01-10-2015<br>03-04-2014 |
| WO 2016205242 A1 | 22-12-2016 | EP 3307426 A1<br>US 2018363136 A1<br>WO 2016205242 A1 | 18-04-2018<br>20-12-2018<br>22-12-2016 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016012046 A1

**In der Beschreibung aufgeführte Nicht-Patentliteratur**

- **P. POODT et al.** High-Speed Spatial Atomic-Layer Deposition of Aluminum Oxide Layers for Solar Cell Passivation. *Adv. Mater.,* 2010, vol. 22, 3564-3567

- **C.Z. LENG et al.** Vapor phase infiltration (VPI) for transforming polymers into organic-inorganic hybrid materials: a critical review of current progress and future challenges. *Mater. Horiz.,* 2017, vol. 4, 747-771